# EUROPÄISCHE PATENTSCHRIFT

(11) **EP 3 162 176 B1**
(45) Veröffentlichungstag und Bekanntmachung des Hinweises auf die Patenterteilung: **14.12.2022**
(21) Anmeldenummer: 15778213.7
(22) Anmeldetag: 08.05.2015
(51) Int. Cl.: H05K 5/00, H05K 9/00

(54) **VORRICHTUNG ZUR ANSTEUERUNG VON PERSONENSCHUTZMITTELN UND VERFAHREN ZUR HERSTELLUNG EINER VORRICHTUNG ZUR ANSTEUERUNG VON PERSONENSCHUTZMITTELN**
DEVICE FOR CONTROLLING PERSON-PROTECTING MEANS AND METHOD FOR PRODUCING A DEVICE FOR CONTROLLING PERSON-PROTECTING MEANS
DISPOSITIF DE COMMANDE DE MOYENS DE PROTECTION DE PERSONNES ET PROCÉDÉ PERMETTANT DE PRODUIRE UN DISPOSITIF DE COMMANDE DE MOYENS DE PROTECTION DE PERSONNES

(30) Priorität: 25.06.2014 DE 102014212243
(43) Veröffentlichungstag der Anmeldung: 03.05.2017
(73) Patentinhaber: Robert Bosch GmbH, 70442 Stuttgart (DE)
(72) Erfinder: ERBE, Christian, Yongin-Si 446-850 (KR); GSCHWIND-SCHILLING, Rainer, 71277 Rutesheim (DE)
(86) Internationale Anmeldenummer: PCT/EP2015/060174
(87) Internationale Veröffentlichungsnummer: WO 2015/197247

(56) Entgegenhaltungen:
- WO-A1-2013/140884
- WO-A1-2014/069644

## Beschreibung

### Stand der Technik

Die Erfindung betrifft eine Vorrichtung zur Ansteuerung von Personenschutzmitteln für ein Fahrzeug sowie ein Verfahren zur Herstellung einer solchen Vorrichtung zur Ansteuerung von Rückhaltemitteln für ein Fahrzeug gemäß den unabhängigen Ansprüchen.

Vorrichtungen zur Ansteuerung von Personenschutzmitteln für Fahrzeuge umfassen typischerweise elektrische und elektronische Bauteile, von denen im Betrieb elektromagnetische Strahlung ausgesandt wird, die zu Störungen in anderen elektrischen Geräten im Fahrzeug oder des Radioempfangs führen kann. Daher werden und müssen alle elektrischen und elektronischen Geräte, die in einem Fahrzeug verbaut werden, eine sogenannte Elektromagnetischen Verträglichkeit (EMV) aufweisen.

Eine gängige Möglichkeit die EMV eines Geräts zu verbessern ist es, Bauteile, die besonders stark strahlen mittels sogenannter Abschirmbleche von den übrigen elektrischen oder elektronischen Geräten abzuschirmen.

Die Nutzung von Schirmblechen ist mit Zusatzkosten und mit zusätzlichem Platz im Gehäuse eines Steuergeräts verbunden.

Aus der WO 2013/140884 A1 ist ein Steuergerät bekannt, das eine exzellente Verlässlichkeit und eine verbesserte Geräuschreduzierung mittels einer günstigen Struktur aufweist. Um diesen Zweck zu erfüllen weise das Steuergerät einen Kunststoffdeckel und eine Metallbodenplatte sowie eine mehrschichtige Leiterplatte auf, auf der elektronische Bauteile auf beiden Seiten angeordnet sind und derart von der Leiterplatte abstehen, dass diese von dem Kunststoffdeckel und dem Metallboden abgedeckt werden..

Aus der WO 2014/069644 A1 ist eine Vorrichtung mit einer on-board Schaltung bekannt, wobei die Schaltung derart mit einem Substrat ausgestattet ist, dass Geräusche von außen am Eindringen gehindert werden und eine Streukapazität zwischen den Komponenten und den internen Leiterbahnen nicht erzeugt wird.

### Offenbarung der Erfindung

Die vorliegende Erfindung möchte diesem Umstand Rechnung tragen. Daher wird ein Verfahren zur Herstellung einer Vorrichtung zur Ansteuerung von Rückhaltemitteln für ein Fahrzeug und eine Vorrichtung zur Ansteuerung von Rückhaltemitteln für ein Fahrzeug vorgeschlagen, die eine hohe EMV besitzt und dabei ohne zusätzliche Abschirmbleche auskommt.

Erreicht wird dies durch eine Vorrichtung nach dem unabhängigen Anspruch 3.

Unter einer Vorrichtung zur Ansteuerung von Personenschutzmitteln für ein Fahrzeug wird vorliegend ein Airbag-Steuergerät verstanden. Ein Airbag-Steuergerät empfängt typischerweise über Sensoren Informationen über ein Unfallgeschehen und löst abhängig von der Auswertung dieser Informationen Personenschutzmitteln aus. Es können aber auch andere Steuergeräte darunter verstanden werden, die, allein oder als Kombinationssteuergerät, dazu geeignet sind Personenschutzmitteln für ein Fahrzeug auszulösen.

Unter Personenschutzmitteln für ein Fahrzeug werden alle Mittel verstanden, die dazu geeignet sind die Folgen für In- bzw. Aufsassen des Fahrzeugs, sowie ggf. Dritten im Falle eines Unfalls oder Beinahe-Unfalls zu minimieren. Darunter zählen zumindest alle Arten von Airbags, Gurtstraffern, Kopfstützen, Sitzfunktionen, Motorhaubenfunktionen.

Unter einem Gehäuse kann vorliegend ein Behälter verstanden werden, der dazu geeignet ist Bauteile der Vorrichtung aufzunehmen und über mechanische oder elektrische Schnittstellen zugänglich zu machen. Typischerweise wird das Gehäuse eines Steuergeräts auch dazu verwendet, das Steuergerät in einem Fahrzeug an seinem bestimmungsgemäßen Ort anzubringen.

Unter einer Leiterplatte wird vorliegend eine Platte zur Aufnahme von elektrischen oder elektronischen Bauteilen verstanden.

Unter einem Innenraum des Fahrzeugs wird vorliegend der Raum verstanden, der von der Karosserie des Fahrzeugs gebildet wird.

Günstig ist es dabei, wenn das zumindest eine elektrische oder elektronische Bauteil auf der Leiterplatte, insbesondere auf der dem Fahrzeuginnenraum abgewandten Seiten (Unterseite) der Leiterplatte angeordnet ist. Dadurch kann die Abschirmwirkung der Leiterplatte besonders gut wirken.

Aufwärts- bzw. Abwärtswandler sind Bauteile, die eine Eingangsspannung in einer bestimmten Höhe in eine Ausgangsspannung in einer im Bezug auf die Eingangsspannung höheren bzw. niedrigeren Höhe bereitstellen. Diese Bauteile umfassen typischerweise eine Wandlerdrossel. Dadurch erhalten sie ein besonders hohes bzw. starkes Potential für elektromagnetische Strahlung und stellen somit eine besonders starke Strahlungsquelle der erfindungsgemäßen Vorrichtung dar. Daher ist es vorteilhaft, wenn das zumindest eine elektrische bzw. elektronische Bauteil der erfindungsgemäßen Vorrichtung ein Aufwärts- bzw. Abwärtswandler ist, da durch die erfindungsgemäße Anordnung des Bauteils ein besonders hoher Anteil der elektromagnetischen Strahlungsquellen der Vorrichtung abgeschirmt werden.

In einer vorteilhaften Ausgestaltung ist das Gehäuse der Vorrichtung derart gestaltet, dass das Gehäuse elektromagnetische Strahlung abschirmt. Durch diese Ausgestaltung der Erfindung wird der Abschirmeffekt der Vorrichtung in vorteilhafter Weise verstärkt, da auch das Gehäuse zur Abschirmung beiträgt.

Noch vorteilhafter ist es, wenn das Gehäuse zumindest teilweise aus Metall, insbesondere aus Blech, besteht. Ein Gehäuse aus Metall verstärkt den Abschirmeffekt des abschirmenden Gehäuses. Wird das Gehäuse aus Metallblech hergestellt, so weist das Gehäuse ein vorteilhaft niedriges Gewicht auf.

Denkbar ist dabei auch ein Gehäuse zu verwenden, das ganz oder teilweise aus Kunststoff besteht, wobei der Kunststoff mit einer ausreichend hohen Anzahl an Metallpartikeln angereichert ist und dadurch den gewünschten Abschirmeffekt erzeugt.

Vorrichtung nach einem der vorhergehenden Ansprüche, wobei die zumindest eine Schicht der Leiterplatte derart gestaltet ist, dass über die Schicht eine elektrische Verbindung zu einem elektrische Massepotenzial herstellbar ist. Eine derart gestaltete Schicht der Leiterplatte wird auch Masselage genannt. Elektronische und elektrische Bauteile können so mit einem Massepotenzial verbunden werden. Dadurch lassen sich in vorteilhafter Weise Potentialunterschiede verhindern. Zeitgleich sorgt eine Masseschicht, in einer ansonsten isolierend wirkenden Leiterplatte, in vorteilhafter Weise abschirmend.

Eine besondere Rolle spielt dabei das Herstellungsverfahren einer solchen Vorrichtung.

Demnach entsteht eine Vorrichtung mit den vorstehend beschriebenen Eigenschaften, wenn es nach dem Herstellungsverfahren gemäß dem unabhängigen Anspruch 1 hergestellt wird.

Wonach eine Leiterplatte in einem Gehäuse der Vorrichtung derart angeordnet wird, dass die Leiterplatte die elektromagnetische Strahlung zumindest eines in dem Gehäuse angeordneten elektrischen oder elektronischen Bauteils der Vorrichtung gegen zumindest den Innenraum des Fahrzeugs abschirmt, wenn die Vorrichtung in dem Fahrzeug angebracht ist.

Vorteilhafte Ausgestaltungen der erfindungsgemäßen Vorrichtung und des erfindungsgemäßen Verfahrens ergeben sich aus den Unteransprüchen und der nachstehenden Beschreibung von bevorzugten Ausführungsformen.

Von Vorteil ist es, wenn vor dem Anordnen der Leiterplatte in dem Gehäuse der Vorrichtung das zumindest eine elektrische bzw. elektronische Bauteil auf der Leiterplatte, insbesondere auf der auf der dem Fahrzeuginnenraum abgewandten Seiten (Unterseite) der Leiterplatte, angeordnet wird. Dadurch wird sichergestellt, dass das zumindest eine elektrische Bauteil so in dem Gehäuse der Vorrichtung angeordnet ist, dass die erfindungsgemäße Anordnung von Leiterplatte und Gehäuse zu einer Abschirmung der elektromagnetischen Strahlung des elektrischen bzw. elektronischen Bauteils und somit zu einer verbesserten EMV der Vorrichtung führt.

Da die erfindungsgemäße Vorrichtung Erschütterungen und Schwingungen im Fahrzeug ausgesetzt ist, hat sich eine stoffschlüssige Verbindung des zumindest einen elektrischen oder elektronischen Bauteils mit der Leiterplatte als vorteilhaft für den Zusammenhalt des Verbundes erwiesen. Zum stoffschlüssigen Verbinden stehen verschiedenste Verfahren zur Verfügung. Im Hinblick auf die typischerweise verwendeten Materialen hat sich Reflow-Löten erwiesen.

Unter Reflow-Löten wird vorstehend verstanden, dass in einem ersten Schritt Lot auf die Leiterplatte aufgetragen wird, in einem nächsten Schritt werden die anzulötenden Bauteile auf der Leiterplatte angeordnet, d.h. bestückt und in einem dritten Schritt wird das Lot aufgeschmolzen, sodass es nach der Erkaltung zu einer stoffschlüssigen Verbindung zwischen den Bauteilen und der Leiterplatte kommt. Besonders vorteilhaft ist es, wenn das elektrische bzw. elektronische Bauteil mittels Reflow-Lötens mit der Leiterplatte verbunden wird und das elektrische bzw. elektronische Bauteil auf der zuerst bearbeiteten Seite der Leiterplatte angeordnet wird. Typischerweise werden Leiterplatten von Vorrichtungen zur Ansteuerung von Personenschutzmitteln beidseitig bestückt. Typischerweise wird dabei die Unterseite der Leiterplatte zuerst mit elektrischen bzw. elektronischen Bauteilen bestückt und mit diesen verbunden. In einem zweiten Schritte wird dann die Oberseite der Leiterplatte mit elektrischen bzw. elektronischen Bauteilen bestückt und mit diesen verbunden.

Vorteilhafte Ausführungsformen der Erfindung sind in den Zeichnungen dargestellt und werden nachfolgend beschrieben. In den Zeichnungen bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische Seitenansicht der erfindungsgemäßen Vorrichtung
Fig. 2 zeigt ein Ablaufdiagramm des erfindungsgemäßen Verfahrens

### Ausführungsformen der Erfindung

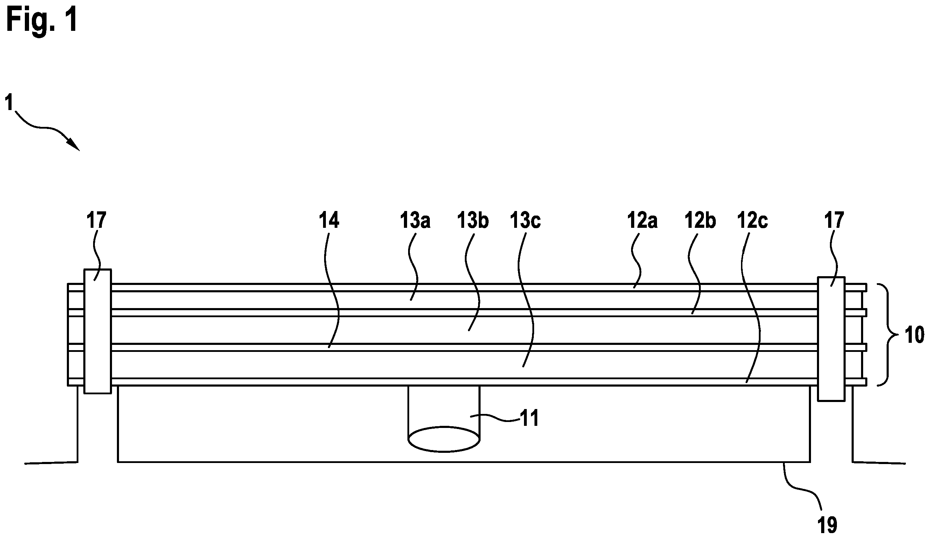

Fig. 1 zeigt eine schematische Seitenansicht der erfindungsgemäßen Vorrichtung.

Die erfindungsgemäße Vorrichtung 1, bspw. ein Steuergerät zur Ansteuerung von Personenschutzmitteln weist ein Gehäuse auf. Dieses Gehäuse besteht typischerweise aus einem Deckel (nicht dargestellt) und einer Bodenplatte 19. Der Deckel und die Bodenplatt 19 bilden den Raum, in den typischerweise die eine Leiterplatte 10 angeordnet ist.

Leiterplatten 10 sind typischerweise in Lagen aufgebaut. Über Verdrahtungslagen 12a, 12b, 12c werden die elektrischen und elektronischen Bauteile, mit denen die Leiterplatte 10 bestückt ist und die Funktion der erfindungsgemäßen Vorrichtung 1 bereitstellen, miteinander verbunden. Über die Masselage 14 wird ein Massepotential zur Verfügung gestellt. Die verschiedenen Lagen sind mittels isolierender Schichten 13a, 13b, 13c voneinander getrennt.

Leiterplatten 10 sind typischerweise mit dem Gehäuse bzw. zumindest mit einem Teil des Gehäuses über ein Verbindungsmittel 17, hier mit der Bodenplatte 19, verbunden. Diese Verbindungsmittel sind typischerweise Schrauben. Allerdings können genauso gut Bolzen oder dgl. verwendet werden.

Typischerweise sorgt zumindest eines der Verbindungsmittel für eine elektrische Verbindung der Masselage 14 mit dem Gehäuse - hier der Bodenplatte 19. Da oft das Verbindungsmittel 17 auch dazu verwendet wird, das Gehäuse im Fahrzeug an seinem bestimmungsgemäßen Ort zu befestigen, wird das zumindest eine Verbindungsmittel dazu genutzt, um eine elektrische Verbindung mit dem Fahrzeug herzustellen.

Das besonders stark strahlende elektrische bzw. elektronische Bauteil 11 wird dabei wie in Fig. 1 dargestellt an der Unterseite der Leiterplatte 10 angeordnet. Die Unterseite definiert sich vorstehend so, dass damit die Seite der Leiterplatte 10 gemeint ist, die von dem Innenraum des Fahrzeugs weg weist, wenn die erfindungsgemäße Vorrichtung 1, hier das Steuergerät, an ihrem bestimmungsgemäßen Ort im Fahrzeug angebracht ist.

Wie in Fig. 1 dargestellt ist das elektrische bzw. elektronische Bauteil 11 - hier der Aufwärts- bzw. Abwärtswandler bzw. die Wandlerdrossel des Aufwärts- bzw. Abwärtswandler an der Unterseite der Leiterplatte 10 angeordnet. So entfaltet die Leiterplatte 10 bzw. die in der Leiterplatte angeordnete Masselage 14 ihre abschirmende Wirkung und sorgt somit für eine höhere Elektromagnetische Verträglichkeit (EMV) der erfindungsgemäßen Vorrichtung 1

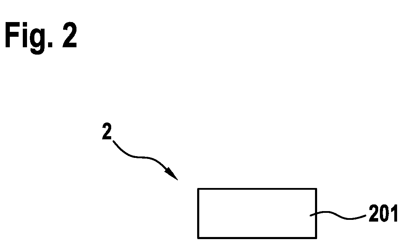

Fig. 2 zeigt das Ablaufdiagramm des Verfahrens zur Herstellung der erfindungsgemäßen Vorrichtung zur Ansteuerung von Personenschutzmitteln.

Schritt 201 repräsentiert das Anordnen der Leiterplatte in einem Gehäuse der Vorrichtung derart, dass die Leiterplatte die elektromagnetische Strahlung zumindest eines in dem Gehäuse angeordneten elektrischen oder elektronischen Bauteils der Vorrichtung gegen zumindest den Innenraum des Fahrzeugs abschirmt, wenn die Vorrichtung in dem Fahrzeug angebracht ist.

Das Anordnen der Leiterplatte in dem Gehäuse kann dabei in einem vorbereitenden Schritt geschehen. Das bedeutet, das Gehäuse und die Leiterplatte der Vorrichtung werden vorverbunden. Eine solche Vorverbindung kann mit lösbaren und nicht-lösbaren Verbindungsmethoden wie Schrauben, Nieten, Klipsen oder Stecken geschehen. Eine endgültige Verbindung des Gehäuses und der Leiterplatte erfolgt dann mit der Anordnen der Vorrichtung an dem bestimmungsgemäßen Ort im Fahrzeug.

Alternativ können das Gehäuse und die Leiterplatte der Vorrichtung endgültig miteinander verbunden werden. Und die Anordnung der Vorrichtung im Fahrzeug erfolgt mit separaten Verbindungsmitteln in einem separaten Schritt.

## Patentansprüche

1. Verfahren (2) zur Herstellung einer Vorrichtung (1) zur Ansteuerung von Rückhaltemitteln für ein Fahrzeug, mit den Schritten:
- Anordnen zumindest eines elektrischen oder elektronischen Bauteils (11) auf der zuerst bearbeiteten Seite einer Leiterplatte (10), wobei die Leiterplatte (10) zumindest eine Schicht (14) zur Abschirmung von elektromagnetischer Strahlung aufweist, wobei das zumindest eine elektrische oder elektronische Bauteil (11) ein Aufwärts- und/oder Abwärtswandler und/oder eine Wandlerdrossel eines Aufwärts- und/oder Abwärtswandlers ist, wobei das elektrische oder elektronische Bauteil (11) mittels Reflow-Lötens stoffschlüssig mit der Leiterplatte (10) verbunden wird;
- Anordnen (201) der Leiterplatte (10) in einem Gehäuse der Vorrichtung (1) derart, dass die Leiterplatte (10) die elektromagnetische Strahlung des zumindest einen, in dem Gehäuse angeordneten elektrischen oder elektronischen Bauteils (11) der Vorrichtung (1) gegen zumindest den Innenraum des Fahrzeugs abschirmt, wenn die Vorrichtung (1) in dem Fahrzeug angebracht ist.

2. Verfahren (2) nach Anspruch 1, wobei im Schritt des Anordnens des zumindest einen elektrischen oder elektronischen Bauteils (11) das elektrische oder elektronische Bauteil (11) auf der dem Fahrzeuginnenraum abgewandten Seite der Leiterplatte (10) angeordnet wird.

3. Vorrichtung (1) zur Ansteuerung von Rückhaltemitteln für ein Fahrzeug, hergestellt mittels des Verfahrens nach Anspruch 1 oder 2, aufweisend ein Gehäuse, zumindest eine Leiterplatte (10) und zumindest ein elektrisches oder elektronisches Bauteil (11), wobei die Leiterplatte (10) zumindest eine Schicht (14) zur Abschirmung von elektromagnetischer Strahlung aufweist, wobei die Leiterplatte (10) derart in dem Gehäuse angeordnet ist, dass wenn die Vorrichtung in dem Fahrzeug angebracht ist, die Leiterplatte (10) die elektromagnetische Strahlung, die das zumindest eine elektrische oder elektronische Bauteil (11) aussendet, gegen zumindest den Innenraum des Fahrzeugs abschirmt, wobei das zumindest eine elektrische oder elektronische Bauteil (11) ein Aufwärts- und/oder Abwärtswandler und/oder eine Wandlerdrossel eines Aufwärts- und/oder Abwärtswandlers ist.

4. Vorrichtung (1) nach Anspruch 3, wobei das zumindest eine elektrische oder elektronische Bauteil (11) auf der Leiterplatte (10), insbesondere auf der dem Fahrzeuginnenraum abgewandten Seite der Leiterplatte 10 angeordnet ist.

5. Vorrichtung (1) nach Anspruch 3 oder 4, wobei das Gehäuse derart gestaltet ist, dass das Gehäuse elektromagnetische Strahlung abschirmt.

6. Vorrichtung (1) nach Anspruch 5, wobei das Gehäuse zumindest teilweise aus Metall, insbesondere aus Blech, besteht.

7. Vorrichtung (1) nach einem Ansprüche 3 bis 6, wobei die zumindest eine Schicht (14) der Leiterplatte (10) derart gestaltet ist, dass über die Schicht (14) eine elektrische Verbindung (17) zu einem elektrische Massepotenzial herstellbar ist.

## Claims

1. Method (2) for producing a device (1) for controlling person-protecting means for a vehicle, having the steps:
- arranging at least one electrical or electronic component (11) on the first-processed side of a circuit board (10), wherein the circuit board (10) has at least one layer (14) for shielding electromagnetic radiation, wherein the at least one electrical or electronic component (11) is an up and/or down converter and/or a converter choke of an up and/or down converter, wherein the electrical or electronic component (11) is integrally connected to the circuit board (10) by means of reflow soldering;
- arranging (201) the circuit board (10) in a housing of the device (1) in such a way that, when the device (1) is fitted in the vehicle, the circuit board (10) shields the electromagnetic radiation of the at least one electrical or electronic component (11) of the device (1) that is arranged in the housing with respect to at least the interior of the vehicle.

2. Method (2) according to Claim 1, wherein, in the step of arranging the at least one electrical or electronic component (11), the electrical or electronic component (11) is arranged on the side of the circuit board (10) that faces away from the vehicle interior.

3. Device (1) for controlling person-protecting means for a vehicle, produced by means of the method according to Claim 1 or 2, having a housing, at least one circuit board (10) and at least one electrical or electronic component (11), wherein the circuit board (10) has at least one layer (14) for shielding electromagnetic radiation, wherein the circuit board (10) is arranged in the housing in such a way that, when the device is fitted in the vehicle, the circuit board (10) shields the electromagnetic radiation which the at least one electrical or electronic component (11) emits with respect to at least the interior of the vehicle, wherein the at least one electrical or electronic component (11) is an up and/or down converter and/or a converter choke of an up and/or down converter.

4. Device (1) according to Claim 3, wherein the at least one electrical or electronic component (11) is arranged on the circuit board (10), in particular on the side of the circuit board (10) that faces away from the vehicle interior.

5. Device (1) according to Claim 3 or 4, wherein the housing is configured in such a way that the housing shields electromagnetic radiation.

6. Device (1) according to Claim 5, wherein the housing consists at least partly of metal, in particular of sheet metal.

7. Device (1) according to one of Claims 3 to 6, wherein the at least one layer (14) of the circuit board (10) is configured in such a way that an electric connection (17) to an electrical earth potential can be produced via the layer (14).

## Revendications

1. Procédé (2) de fabrication d'un dispositif (1) permettant de piloter des moyens de retenue pour un véhicule, comprenant les étapes consistant à :
- disposer au moins un composant électrique ou électronique (11) sur la face traitée en premier d'une carte de circuits imprimés (10), dans lequel la carte de circuits imprimés (10) présente au moins une couche (14) pour faire écran à un rayonnement électromagnétique, dans lequel ledit au moins un composant électrique ou électronique (11) est un convertisseur élévateur et/ou abaisseur et/ou une inductance de convertisseur d'un convertisseur élévateur et/ou abaisseur, dans lequel le composant électrique ou électronique (11) est relié par liaison de matière à la carte de circuits imprimés (10) au moyen d'un soudage par refusion ;
- disposer (201) la carte de circuits imprimés (10) dans un boîtier du dispositif (1) de telle sorte que la carte de circuits imprimés (10) fait écran au rayonnement électromagnétique du au moins un composant électrique ou électronique (11), disposé dans le boîtier, du dispositif (1) au moins par rapport à l'espace intérieur du véhicule lorsque le dispositif (1) est monté dans le véhicule.

2. Procédé (2) selon la revendication 1, dans lequel, à l'étape de disposition du au moins un composant électrique ou électronique (11), le composant électrique ou électronique (11) est disposé sur la face de la carte de circuits imprimés (10), détournée de l'espace intérieur de véhicule.

3. Dispositif (1) permettant de piloter des moyens de retenue pour un véhicule, fabriqué au moyen du procédé selon la revendication 1 ou 2, présentant un boîtier, au moins une carte de circuits imprimés (10) et au moins un composant électrique ou électronique (11), dans lequel la carte de circuits imprimés (10) présente au moins une couche (14) pour faire écran à un rayonnement électromagnétique, dans lequel la carte de circuits imprimés (10) est disposée dans le boîtier de telle sorte que lorsque le dispositif est monté dans le véhicule, la carte de circuits imprimés (10) fait écran au rayonnement électromagnétique émis par ledit au moins un composant électrique ou électronique (11) au moins par rapport à l'espace intérieur du véhicule, dans lequel ledit au moins un composant électrique ou électronique (11) est un convertisseur élévateur et/ou abaisseur et/ou une inductance de convertisseur d'un convertisseur élévateur et/ou abaisseur.

4. Dispositif (1) selon la revendication 3, dans lequel ledit au moins une composant électrique ou électronique (11) est disposé sur la carte de circuits imprimés (10), en particulier sur la face de la carte de circuits imprimés (10), détournée de l'espace intérieur de véhicule.

5. Dispositif (1) selon la revendication 3 ou 4, dans lequel le boîtier est configuré de telle sorte que le boîtier fait écran au rayonnement électromagnétique.

6. Dispositif (1) selon la revendication 5, dans lequel le boîtier est au moins partiellement en métal, en particulier en tôle.

7. Dispositif (1) selon l'une quelconque des revendications 3 à 6, dans lequel ladite au moins une couche (14) de la carte de circuits imprimés (10) est configurée de telle sorte qu'une liaison électrique (17) avec un potentiel de masse électrique peut être établie par l'intermédiaire de la couche (14).
